Europäisches Patentamt

European Patent Office

Office européen des brevets

(19)

(11) Veröffentlichungsnummer: **0 354 313**
**A2**

## (12) EUROPÄISCHE PATENTANMELDUNG

(21) Anmeldenummer: **89110072.9**

(22) Anmeldetag: **03.06.89**

(51) Int. Cl.⁴: **H03J 9/06**

(30) Priorität: **11.08.88 DE 3827211**

(43) Veröffentlichungstag der Anmeldung:
**14.02.90 Patentblatt 90/07**

(84) Benannte Vertragsstaaten:
**AT DE FR GB IT**

(71) Anmelder: **GRUNDIG E.M.V.**
**Elektro-Mechanische Versuchsanstalt Max**
**Grundig holländ. Stiftung & Co. KG.**
**Kurgartenstrasse 37**
**D-8510 Fürth/Bay.(DE)**

(72) Erfinder: **Rosenberger, Winfried c/o Grundig**
**E.M.V.**
**holländ. Stiftung & Co KG Kurgartenstrasse**
**37**
**D-8510 Fürth/Bay(DE)**

(54) **Einrichtung zur Überführung von Abstimmdaten in Empfangsgeräte.**

(57) Eine bekannte Einrichtung zur Überführung von Abstimmdaten in Empfangsgeräte weist einen nichtflüchtigen Abstimmdatenspeicher auf, von dem aus die Abstimmdaten in die Abstimmdatenspeicher der Empfangsgeräte übertragen werden. Die Einspeisung der Abstimmdaten in die bekannte Einrichtung erfolgt umständlich unter Verwendung einer auf der bekannten Einrichtung angeordneten Tastatur. Bei der neuen Einrichtung soll die Einspeisung der Abstimmdaten vereinfacht sein.

Dies wird dadurch erreicht, daß die Einrichtung zur Überführung von Abstimmdaten in Empfangsgeräte eine Anschlußbuchse aufweist, über die die im nichtflüchtigen Abstimmdatenspeicher abzuspeichernden Abstimmdaten eingespeist werden. Empfangsgeräte der Unterhaltungselektronik

EP 0 354 313 A2

## EINRICHTUNG ZUR ÜBERFÜHRUNG VON ABSTIMMDATEN IN EMPFANGSGERÄTE

Die Erfindung betrifft eine Einrichtung zur Überführung von Abstimmdaten in Empfangsgeräte mit den im Oberbegriff des Anspruchs 1 angegebenen Merkmalen.

Eine derartige Einrichtung ist aus der DE-OS 36 42 365 der Anmelderin bekannt. Die bekannte Einrichtung geht von der Erkenntnis aus, daß aufgrund des zunehmenden Programmangebotes, insbesondere auch über Kabel und Satellit, der Abstimmvorgang von Empfangsgeräten bei deren Inbetriebnahme immer aufwendiger und zeitintensiver wird. Um den Abstimmvorgang zu vereinfachen und zu beschleunigen ist bei der bekannten Einrichtung ein nichtflüchtiger Abstimmdatenspeicher vorgesehen, in welchen die Abstimmdaten mittels einer Tastatur eingegeben werden. Von dieser Einrichtung mit dem nichtflüchtigen Abstimmdatenspeicher aus kann beispielsweise der Fachhändler bei der Aufstellung bzw. Inbetriebnahme des Empfangsgerätes die Abstimmdaten in den Abstimmdatenspeicher des Empfangsgerätes übertragen.

Eine ähnliche Einrichtung ist aus der DE-OS 36 40 437 bekannt.

Weiterhin ist es aus der nicht vorveröffentlichten Patentanmeldung P 37 13 235.0 der Anmelderin bekannt, als nichtflüchtiger Abstimmdatenspeicher eine Magnetbandcassette zu verwenden, auf der die Abstimmdaten in geeigneter Form aufgezeichnet sind.

Die Aufgabe der Erfindung besteht darin, bei einer Einrichtung der im Oberbegriff des Anspruchs 1 angegebenen Art einen Weg aufzuzeigen, wie die Eingabe der Abstimmdaten in den nichtflüchtigen Abstimmdatenspeicher vereinfacht werden kann.

Diese Aufgabe wird bei einer Einrichtung der im Oberbegriff des Anspruchs angegebenen Art durch die im kennzeichnenden Teil des Anspruchs 1 angegebenen Merkmale gelöst.

Vorteilhafte Ausgestaltungen der beanspruchten Einrichtung ergeben sich aus den Unteransprüchen.

Die Vorteile der Erfindung ergeben sich aus der Erläuterung eines Ausführungsbeispieles anhand der (einzigen) Figur.

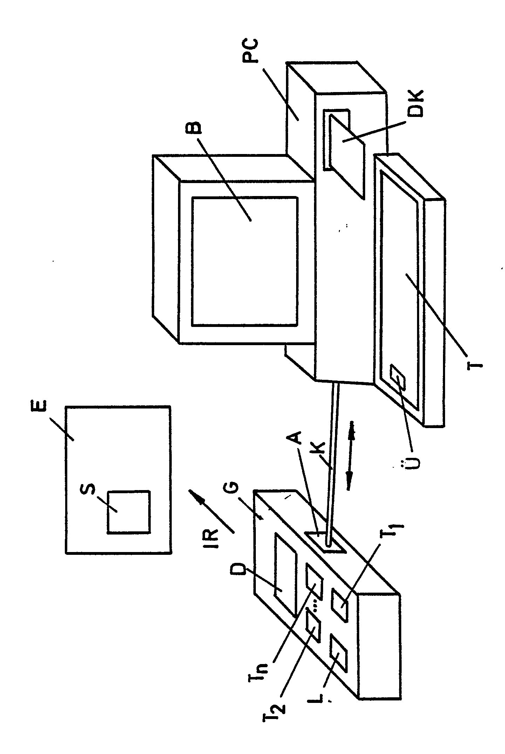

Die Figur zeigt ein zu programmierendes Empfangsgerät E mit einem Abstimmdatenspeicher S, eine Einrichtung G zur Überführung von Abstimmdaten in Empfangsgeräte und einen Personal-Computer PC mit einem Bildschirm B und einer Tastatur T. Die Einrichtung G enthält ein Display D, Tasten T 1...T n, eine Ladetaste L, eine Anschlußbuchse A und einen (nicht gezeichneten) nichtflüchtigen Abstimmdatenspeicher. In den Personal-Computer PC ist eine Diskette DK ladbar, auf der ein Programm abgespeichert ist, welches vom Hersteller des zu programmierenden Gerätes E vorgegeben ist und zur Generierung der Abstimmdaten verwendet wird. Die Einrichtung G ist über ein Kabel K mit dem Personal-Computer (PC) verbunden.

Die Einspeisung der Abstimmdaten in die Einrichtung G geschieht wie folgt:

Nach der Betätigung einer Ladetaste L auf der Einrichtung G wird ein Startsignal erzeugt und damit die Kommunikationsschnittstelle für die Kommunikation mit dem Personal-Computer PC generiert. Damit ist die Einrichtung G zur Übernahme von Daten bereit.

Nach dem Einlegen einer Diskette DK in den Personal-Computer PC wird ein auf der Diskette DK abgespeichertes Programm gestartet. Das Programm listet auf dem Bildschirm B Abstimmdaten bzw. Daten für Kanäle, Sonderkanäle, Senderkennungen usw. in Tabellenform auf. Diese Daten sind entweder ebenfalls auf der Diskette DK abgespeichert oder werden aus dem nichtflüchtigen Abstimmdatenspeicher der Einrichtung G ausgelesen und dem Personal-Computer PC bzw. dessen Bildschirm B über das Verbindungskabel K zugeführt. Unter Verwendung der Tastatur T können diese Abstimmdaten modifiziert werden. Sind die gewünschten Abstimmdaten mittels der Tastatur T eingegeben, so wird eine Übernahmetaste Ü auf der Tastatur T des Personal-Computers PC betätigt. In Ansprache auf diese Tastenbetätigung werden die Abstimmdaten vom Personal-Computer PC über dessen (nicht gezeichnete) Druckerschnittstelle und das Verbindungskabel K in den nichtflüchtigen Abstimmdatenspeicher der Einrichtung G übertragen.

Von dort aus können die Abstimmdaten bei der Inbetriebnahme eines Empfangsgerätes E in dessen Abstimmdatenspeicher S geladen werden. Die letztgenannte Datenübertragung kann leitungslos, beispielsweise mittels einer Infrarot-Übertragung, oder auch über ein Verbindungskabel, erfolgen.

**Ansprüche**

1. Einrichtung zur Überführung von Abstimmdaten in Empfangsgeräte, welche einen nichtflüchtigen Abstimmdatenspeicher aufweist, von dem aus die Abstimmdaten in die Abstimmdatenspeicher der Empfangsgeräte übertragen werden, **dadurch gekennzeichnet**, daß sie eine Anschlußbuchse (A) aufweist, über die die im nichtflüchtigen Abstimmdatenspeicher abzuspeichernden Abstimmdaten eingespeist werden.

2. Einrichtung nach Anspruch 1, **dadurch ge-**

kennzeichnet, daß die über die Anschlußbuchse (A) eingespeisten Abstimmdaten in einem Personal-Computer (PC) erzeugt werden.

3. Einrichtung nach Anspruch 2, **dadurch gekennzeichnet**, daß die im Personal-Computer (PC) erzeugten Abstimmdaten über die Druckerschnittstelle des Personal-Computers (PC) ausgegeben und über ein Verbindungskabel (K) an die Anschlußbuchse (A) der Einrichtung (G) weitergegeben werden.

4. Einrichtung nach Anspruch 3, **dadurch gekennzeichnet**, daß
- sie eine Ladetaste (L) aufweist, durch deren Betätigung die Einrichtung (G) zur Übernahme von Abstimmdaten vorbereitet wird,
- ein auf einer Diskette (DK) gespeichertes Programm aufgerufen wird, welches Abstimmdaten auf einem Bildschirm (B) des Personal-Computers (PC) auflistet, und
- die auf dem Bildschirm (B) aufgelisteten Abstimmdaten mittels der Tastatur (T) des Personal-Computers (PC) modifizierbar sind.

5. Einrichtung nach Anspruch 4, **dadurch gekennzeichnet**, daß die auf dem Bildschirm (B) des Personal-Computers (PC) aufgelisteten Abstimmdaten auf der Diskette (DK) abgespeichert sind.

6. Einrichtung nach Anspruch 4, **dadurch gekennzeichnet**, daß die auf dem Bildschirm (B) des Personal-Computers (PC) aufgelisteten Abstimmdaten aus dem nichtflüchtigen Speicher der Einrichtung (G) ausgelesen werden.

E

S

IR

D

G

Tn

T2

A

K

L

T1

Ü

T

B

PC

DK

EP 0 354 313 A2